# EUROPÄISCHE PATENTSCHRIFT

(11) **EP 1 548 829 B1**
(45) Veröffentlichungstag und Bekanntmachung des Hinweises auf die Patenterteilung: **05.10.2011**
(21) Anmeldenummer: 04025145.6
(22) Anmeldetag: 22.10.2004
(51) Int. Cl.: H01L 25/07

(54) **Leistungshalbleitermodul und Verfahren seiner Herstellung**
Power semiconductor module and method for its manufacture
Module à semi-conducteur de puissance et procédé pour sa fabrication

(30) Priorität: 29.11.2003 DE 10355925
(43) Veröffentlichungstag der Anmeldung: 29.06.2005
(73) Patentinhaber: SEMIKRON Elektronik GmbH & Co. KG, 90431 Nürnberg (DE)
(72) Erfinder: Göbl, Christian, 90441 Nürnberg (DE); Heilbronner, Heinrich, Dr., 90547 Stein (DE)

(56) Entgegenhaltungen:
- WO-A-01/24260
- WO-A-03/030247
- DE-A1- 10 121 970
- JP-A- 63 126 240
- FILLION R ET AL: "A HIGH PERFORMANCE POLYMER THIN FILM POWER ELECTRONICS PACKAGING TECHNOLOGY" ADVANCING MICROELECTRONICS, IMAPS, RESTON, VA, US, Bd. 30, Nr. 5, 1. September 2003 (2003-09-01), Seiten 7-12, XP009047125

## Beschreibung

Die Erfindung beschreibt ein Leistungshalbleitermodul und ein Verfahren zu dessen Herstellung zur Kontaktierung von Halbleiterbauelementen, speziell Leistungshalbleiterbauelementen wie Transistoren, Thyristoren oder Dioden, miteinander und / oder mit zugeordneten Anschlussleitern. Derartige Leistungshalbleitermodule sind zur Erhöhung ihrer Leistungsfähigkeit, ihrer Zuverlässigkeit sowie ihrer Lebensdauer bei gleichzeitig verringerten Herstellungskosten und Baugröße steter Gegenstand der Forschung.

Ausgangspunkt der Erfindung sind die eigenen Patentanmeldungen DE 101 21 970 A1, sowie die nicht vorveröffentlichte DE 102 58 565. Die DE 101 21 970 offenbart ein Leistungshalbleitermodul bestehend aus einem Substrat mit hierauf angeordneten schaltungsgerecht strukturierten Leiterbahnen und hierauf angeordneten Leistungshalbleiterbauelementen. Die Kontaktierung dieser Leistungshalbleiterbauelemente erfolgt mittels einer flexiblen Leiterplatte, wobei die flexible Leiterplatte Kontaktnoppen und Durchkontaktierungen aufweist. Die Druckkontaktierung erfolgt mittels eines elastischen Druckspeichers und einer Druck einleitenden Druckplatte. Nachteilig hierbei ist, dass ein kompakter Aufbau auf Grund der für die Kontaktierung der Leistungshalbleiterbauelemente und der Leiterbahnen des Substrats notwendigen Biegeradien der flexiblen Leiterplatte nicht möglich ist. Weiterhin nachteilig ist, dass die Justage der flexiblen Leiterplatte zu den vorher auf dem Substrat angeordneten Leistungshalbleiterbauelementen und den weiteren Kontaktflächen aufwändig ist.

Die DE 102 58 565 offenbart ein Leistungshalbleitermodul in Druckkontaktierung mit zwei metallischen Anschlussleitern, wobei die Druckeinleitung über diese beiden Anschlussleiter erfolgt. Zwischen den Leistungshalbleiterbauelementen und den Anschlussleitungen ist eine Isolationsschicht mit Durchkontaktierungen angeordnet. In diese Isolationsschicht ist die Leitungsführung der Steueränschlüsse eingebettet. Nachteilig bei dieser Ausgestaltung des Leistungshalbleitermoduls ist, dass durch die offenbarte Anordnung keine komplexen Schaltungstopologien darstellbar sind. Weiterhin nachteilig ist, dass die Herstellung durch die Justage mehreren Lagen (des ersten Anschlussleiters, des Substrats mit den Leistungshalbleiterbauelementen, mindestens einer Isolationsschicht und des zweiten Anschlussleiters) zueinander sehr aufwändig ist.

Die JP 63126240 offenbart demgegenüber ein Schweißverfahren für LSI Chips zur Verbindung mit eine flexiblen Verbindungseinrichtung, mit einer isolierenden Schicht, die bei der Ausbildung der Verbindung verformt wird.

Die Dokumente DE 101 21 970, WO 01/24260 A1 und der Artikel "A high performance polymer thin film power elektronics packaging technology" Filon et al. Advancing Microelectronics, IMAPS, Reston, VA, US, Vol. 30 No. 5, pp 7-12 offenbaren verschiedene Verfahren zur Herstellung eines Leistungshalbleitermoduls mit den folgenden Schritten:
- Herstellen eines Folienverbundes aus mindestens zwei metallischen Folienschichten sowie jeweils einer dazwischen angeordneten elektrisch isolierenden Folienschicht,
- Schaitungsgerechte Strukturierung mindestens einer metallischer Folienschicht des Folienverbandes;
- Herstellung von schaltungsgerechten Durchkontaktierungen zwischen verschiedenen metallischen Folienschichten;
- Ausbildung von Kontaktnoppen auf dem Folienverbund;
- Herstellen einer dauerhaften Verbindung zwischen den Kontaktnoppen und den Leistungshalbleiterbauelementen sowie den Distanzelementen, und
- Verbinden des Verbundes aus Folienverbund, Leistungshalbleiterbauelementen und Distanzelementen mit den Leiterbahnen des Substrats mittels Druckkontaktierung, Löt- oder Klebeverbindung.

Die vorliegende Erfindung hat die Aufgabe ein Leistungshalbleitermodul sowie ein zugehöriges Herstellungsverfahren vorzustellen, wobei das Leistungshalbleitermodul zuverlässig und äußerst kompakt gestaltet ist, und das Herstellungsverfahren eine automatisierte Fertigung mit einer geringen Anzahl von Einzelschritten gestattet.

Die beiden Teile der Aufgabe werden gelöst durch ein Leistungshalbleitermodul mit den Merkmalen des Anspruchs 1 sowie durch ein Herstellungsverfahren nach Anspruch 2. Bevorzugte Weiterbildungen finden sich in den Unteransprüchen.

Der Grundgedanke des erfindungsgemäßen Leistungshalbleitermoduls basiert auf dem bekannten Aufbau mit einem Substrat, mit hierauf schaltungsgerecht angeordneten Leiterbahnen und hierauf angeordneten Leistungshalbleiterbauelementen sowie einer weiteren Verbindungstechnik dieser Leistungshalbleiterbauelemente untereinander, mit den Leiterbahnen und / oder mit Anschlussleitern zur externen Kontaktierung. Die erfindungsgemäße Verbindungstechnik basiert auf mindestens einem Folienverbund aus zwei metallischen Folien mit einer dazwischen angeordneten elektrisch isolierenden Folienschicht, wobei mindestens eine metallische Folienschicht schaltungsgerecht strukturiert ist.

Das Leistungshalbeitermodul weist vorzugsweise weitere Bauteile, sog. Distanzelemente, auf. Diese Distanzelemente weisen ihrerseits innerhalb technologischer Grenzen die gleiche Dicke auf wie die Leistungshalbleiterbauelemente. Auf den Leiterbahnen des Substrats sind sowohl diese Distanzelemente als auch die Leistungshalbleiterbauelemente jeweils mit ihrer zweiten Hauptfläche angeordnet. Auf den ersten Hauptflächen der Distanzelemente und Leistungshalbleiterbauelemente ist der mindestens ein Folienverbund angeordnet. Dieser Folienverbund weist zur Kontaktierung mit den Leistungshalbleiterbauelemente und / oder den Distanzelementen vorzugsweise geprägte Kontaktnoppen auf. Diese Kontaktnoppen des Folienverbunds sind mittels Ultraschallschweißen mit den Distanzelementen und / oder Leistungshalbleiterbauelementen dauerhaft und zuverlässig verbunden ist.

Das zugehörige Verfahren zur Herstellung eines derartigen Leistungshalbleitermoduls besteht aus den im Folgenden genannten wesentlichen Schritten. In einem ersten Schritt wird ein Folienverbund aus mindesten zwei metallischen Folienschichten sowie jeweils einer dazwischen angeordneten elektrisch isolierenden Folienschicht hergestellt. Vorzugsweise werden die einzelnen Folienschichten hierbei mittels eines Klebeverfahrens zueinander fixiert. Anschließend folgt die schaltungsgerechte Strukturierung mindestens einer metallischer Folienschicht des Folienverbandes. Weiterhin werden schaltungsgerechte Durchkontaktierungen zwischen verschiedenen metallischen Folienschichten hergestellt. Anschließend werden die Kontaktnoppen vorzugsweise in einem Prägeverfahren erzeugt. Der Folienverbund wird an diesen Kontaktnoppen mittels Ultraschallschweißen mit den Leistungshalbleiterbauelementen sowie den Distanzelementen dauerhaft verbunden. Der Verbund aus Folienverbund, Leistungshalbleiterbauelementen und Distanzelementen wird abschließend auf den Leiterbahnen des Substrats mittels Druckkontaktierung, Löt- oder Klebeverbindung angeordnet.

Nachfolgend werden die Merkmale und Ausgestaltungen der Erfindung anhand der Fig. 1 bis 5 beispielhaft erläutert.Fig. 1 zeigt eine Ausgestaltung eines erfindungsgemäßen Leistungshalbleitermoduls.

Fig. 2 zeigt beispielhaft eine, mittels eines erfindungsgemäßen Leistungshalbleitermoduls ausgestaltet Schaltungsanordnung.

Fig. 3 zeigt die Ausgestaltung einer ersten metallischen Folienschicht eines erfindungsgemäßen Leistungshalbleitermoduls.

Fig. 4 zeigt die Ausgestaltung einer zweiten metallischen Folienschicht eines erfindungsgemäßen Leistungshalbleitermoduls.

Fig. 5 zeigt die Ausgestaltung eines Substrats eines erfindungsgemäßen Leistungshalbleitermoduls.

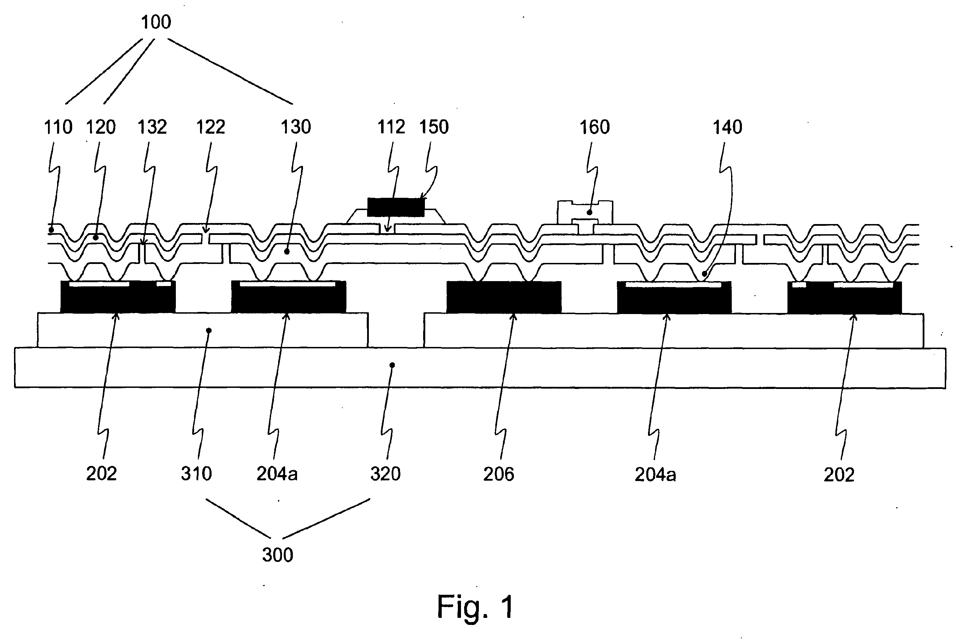

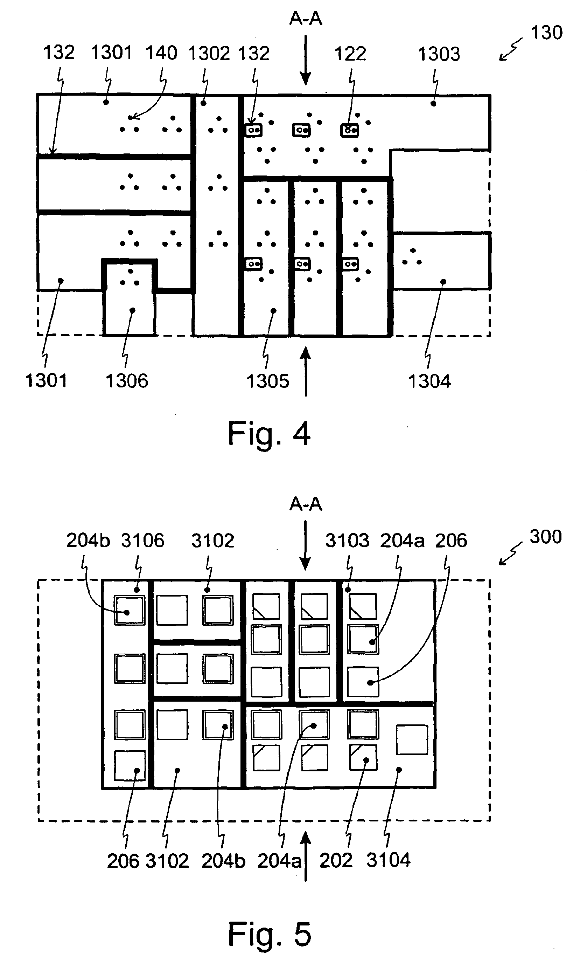

Fig. 1 zeigt eine Ausgestaltung eines erfindungsgemäßen Leistungshalbleitermoduls im Schnitt längs der Linie A-A (vgl. Fig. 4 und 5). Dieses Leistungshalbleitermodul besteht aus einem Substrat (300), welches seinerseits aus einem Isolierstoffkörper (320) sowie hierauf angeordneten und schaltungsgerecht strukturierten Leiterbahnen (310) besteht. Auf diesen Leiterbahnen (310) ist ein Verbund aus Leistungshalbleiterbauelementen (202, 204), Distanzelementen (206) und einem Folienverbund (100) angeordnet. Hierzu wird dieser Verbund mit den Leiterbahnen löttechnisch verbunden. Als Alternativen hierzu sind nach dem Stand der Technik ebenso Klebeverbindungen oder eine Druckkontaktierung bekannt.

Der Verbund aus Leistungshalbleiterbauelementen (202, 204), Distanzelementen (206) und einem Folienverbund (100) entsteht seinerseits durch eine Ultraschallschweißverbindung der geprägten Kontaktnoppen (140) des Folienverbundes (100) mit den Distanzelementen (206) und den Leistungshalbleiterbauelementen (202, 204).

Der Folienverbund (100) selbst besteht aus einer die erste metallische Folienschicht bildenden Kupferfolie (110) mit einer Stärke zwischen 10µm und 50µm, einer elektrisch isolierenden Kunststofffolie (120) mit einer Stärke zwischen 10µm und 50µm und einer die zweite metallische Folienschicht bildenden Aluminiumfolie (130) mit einer Stärke zwischen 100µm und 400µm. Diese einzelnen Folienschichten (110, 120, 130) sind mittels Klebeverbindungen miteinander verbunden sind. Hierbei dient die Kupferfolie (110) als Leiterbahn der Steuer- und Hilfsanschlüsse, wie beispielhaft der Gateanschlüsse, der Hilfsemitteranschlüsse oder der Anschlüsse von Sensorikbauelementen. Die Aluminiumfolie (110) dient als Leiterbahn für die Lastanschlüsse des Leistungshalbleitermoduls. Vorteilhafterweise sind beide Metallfolien (110, 130) hierzu in sich strukturiert (112, 132). Um beispielhaft Hilfsemitteranschlüsse zu realisieren weist der Folienverbund Durchkontaktierungen (122) zwischen den beiden Metallfolien (110, 130) auf.

Diese Durchkontaktierungen (122) können vorzugsweise durch Laserbohren und anschließendes lasergestütztes Verfüllen mit einem leitfähigen Werkstoff hergestellt werden. Hierbei sind Durchkontaktierungen (122) mit einem Durchmesser von einigen hundert Mikrometer möglich.

Auf der Kupferfolie (110) können weitere Bauelemente wie Sensorikbauelemente, Widerstände (160), Kondensatoren, Spulen und / oder integrierte Schaltungen (150) angeordnet werden. Hierzu werden löttechnische Verbindungen bevorzugt. Derartige dort angeordnete Bauelemente (150, 160) können einzelne Funktionen der Ansteuerung des Leistungshalbleitermoduls übernehmen. Ebenso kann die vollständige Treiberschaltung hier angeordnet werden.

Die Distanzelemente (206) dienen dem elektrischen Kontakt zwischen dem Folienverbund (100) und den Leiterbahnen (310) des Substrats (300). Da bei kompakten Aufbauten des Leistungshalbleitermoduls der Folienverband (100) nicht direkt mit den Leiterbahnen (310) des Substrats (300) kontaktiert werden kann, bilden diese Distanzelemente eine elektrisch leitende Verbindung. Vorzugsweise sind die Distanzelemente (206) als Aluminiumquader mit einer Höhe von ±10% der Höhe der Leistungshalbleiterbauelemente (202, 204) ausgestaltet.

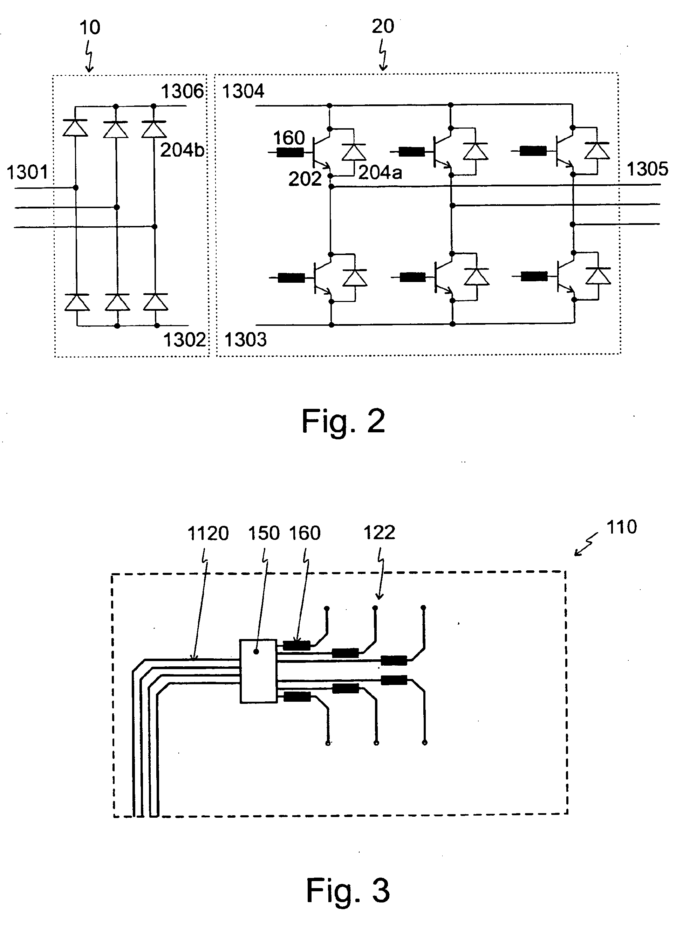

Fig. 2 zeigt beispielhaft eine, mittels eines erfindungsgemäßen Leistungshalbleitermoduls ausgestaltete Schaltungsanordnung. Dargestellt ist die bekannte Schaltungsanordnung eines Umrichters, wobei hier auf das Darstellen eines Gleichstromzwischenkreises verzichtet wurde, da dieser nicht integraler Bestandteil des beispielhaft dargestellten Leistungshalbleitermoduls ist. Den Eingang dieses Umrichters bilden drei Wechselstromphasen (1301). Diese werden mittels eines Brückengleichrichters (10) aufgebaut aus sechs identischen Dioden (204b) gleichgerichtet. Der Brückengleichrichter (10) weist einen positiven (1306) und einen negativen (1302) Ausgang auf.

Der zweite Teil der Schaltungsanordnung ist der Wechselrichter (20) mit dem positiven (1304) und dem negativen (1303) Gleichspannungseingang, sowie den drei identischen Halbbrückenschaltungen. Jede Halbbrückenschaltung besteht aus einem oberen und einem unteren Leistungshalbleiterschalter, hier jeweils einem IGBT (202), mit jeweils einer antiparallel geschalteten Freilaufdiode (204a). Vor jedem Gate eines IGBTs (202) ist weiterhin ein Vorwiderstand (160) dargestellt. Den Ausgang des Wechselrichters bilden die drei Wechselspannungsphasen (1305).

Fig. 3 zeigt die Ausgestaltung einer ersten metallischen Folienschicht, hier der Kupferfolie (110) des in Fig. 1 gezeigten erfindungsgemäßen Leistungshalbleitermoduls. Dargestellt ist im Vergleich zu Fig. 1 die Draufsicht aus Richtung des Folienverbundes (100). Diese Darstellung wird auch bei den Fig. 4 und 5 beibehalten. Die gestrichelte Linie symbolisiert in den Fig. 3 bis 5 den äußersten Rand des Leistungshalbleitermoduls mit dem Folienverbund (100), den Distanz- (206) und Leistungshalbleiterbauelementen (202, 204) und dem Substrat (300).

Die dargestellte Kupferfolie (110) ist in sich derartig strukturiert, dass eine Mehrzahl von einzelnen Leiterbahnen (1120) gebildet werden. Diese Leiterbahnen verbinden eine nicht dargestellt externe Steuerung mit einer integrierten Schaltung (150) zur Ansteuerung der Gates der Leistungstransistoren (vgl. Fig. 5). Weitere Anschlussleitungen für Steuer- und Hilfskontaktierungen, wie beispielhaft für hier nicht dargestellte Hilfsemitter oder Sensorikbauteile, sind ebenfalls als Leiterbahnen (1120) der Kupferfolie (110) ausgebildet. Für die hierzu notwendigen Verbindungen weist die Kupferfolie Durchkontaktierungen (122) zu isolierten Bereichen der Aluminiumfolie (vgl. Fig. 4) auf, die von dort beispielhaft mit den Gates der Leistungstransistoren verbunden sind. Weiterhin sind auf dieser Kupferfolie (110) zwischen der integrierten Schaltung (150) und den Durchkontaktierungen Widerstände (160), hier Gatevorwiderstände, angeordnet.

Fig. 4 zeigt die Ausgestaltung einer weiteren metallischen Folienschicht hier der Aluminiumfolie (130) des in Fig. 1 gezeigten erfindungsgemäßen Leistungshalbleitermoduls in gleicher Draufsicht wie in Fig. 3 beschrieben. Die Aluminiumfolie (130) ist in einzelnen Leiterbahnen (1301, 1302, 1303, 1304, 1305, 1306) strukturiert (132). Die einzelnen Leiterbahnen sind in gleicher Weise benannt wie die Anschlüsse in Fig. 2. Den drei Eingangsphasen sind somit drei gleichartige Leiterbahnen (1301) zugeordnet, ebenso sind den drei Ausgangsphasen die drei gleichartigen Leiterbahnen (1305) zugeordnet. Die Gleichspannungsausgänge des Gleichrichters werden durch die zugeordneten Leiterbahnen (1302, 1306) sowie die Gleichspannungseingänge des Wechselrichters durch die zugeordneten Leiterbahnen (1303, 1304) gebildet. Alle Leistungskontaktierungen sind somit als definierte Bereiche der Aluminiumfolie (130) ausgebildet.

Die Leiterbahnen der Aluminiumfolie (130) weisen zur Verbindung mit den Distanzelementen (206) und den Leistungshalbleiterbauelementen (202, 204) (vgl. Fig. 5) geprägte Kontaktnoppen (140) auf. Weiterhin weist die Aluminiumfolie (130) isolierte Bereiche von Durchkontaktierungen, ausgehend von der Kupferfolie (110) (vgl. Fig. 3), auf.

Fig. 5 zeigt die Ausgestaltung des Substrats (300) eines erfindungsgemäßen Leistungshalbleitermoduls. Auf einem Isolierstoffkörper sind einzelne voneinander isolierte Leiterbahnen (3102, 3103, 3104, 3106) angeordnet. Hierauf sind die zugeordneten Leistungshalbleiterbauelemente und die Distanzbauelemente angeordnet. Die drei Eingangsphasen des Brückengleichrichters (10) sind über die zugeordneten Leiterbahnen (1301) der Aluminiumfolie (130) (vgl. Fig. 4) mit den Anoden der auf der Leiterbahnen (3106) angeordneten Dioden (204b) und über die auf den Leiterbahnen (3102) der Aluminiumfolie angeordneten Distanzelemente (206) mit den Kathoden der ebenfalls dort angeordneten Dioden (204b) verbunden. Die Anoden dieser Dioden sind mit der Leiterbahn (1302) und damit mit dem zugeordneten negativen Ausgang des Brückengleichrichters verbunden. Den positiven Ausgang bildet die Leiterbahn (3106) des Substrats die über ein Distanzelement (206) mit der Leiterbahn (1306) der Aluminiumfolie verbunden ist.

Der positive Gleichspannungseingang des Wechselrichters entspricht der zugeordneten Leiterbahn (1304) der Aluminiumfolie. Diese ist über ein Distanzelement (206) mit der Leiterbahn (3104) des Substrats (300) verbunden und somit mit den Kollektoren der drei oberen Leistungstransistoren (202) sowie den Kathoden der zugeordneten antiparallel geschalteten Dioden (204a). Die Emitter dieser Leistungstransistoren (202) sind ebenso wie die Anoden der zugeordneten Dioden (204a) mit den drei Leiterbahnen (1305) der Aluminiumfolie (130) verbunden. Diese sind über Distanzelemente (206) mit den drei Leiterbahnen (3103) des Substrats und somit mit den Kollektoren der unteren Leistungstransistoren (202) und den Kathoden der ihnen zugeordnete antiparallel geschalteten Dioden (204a) verbunden. Gleichzeitig dienen die drei Leiterbahnen (1305) der Aluminiumfolie (130) als Wechselspannungsausgänge des Wechselrichters. Die Emitter der unteren Leistungstransistoren (202) sowie die Anoden der ihnen zugeordneten Dioden (204a) sind mit der Leiterbahn (1303) und somit mit dem zugeordneten negativen Gleichspannungsanschluss des Wechselrichters verbunden.

Das erfinderische Herstellungsverfahren wird im Folgenden ebenfalls anhand der Fig. 3 bis 5 beispielhaft erläutert. Ausgangspunkt ist das Herstellen eines Folienverbundes aus einer Kupferfolie (110) mit einer Stärke zwischen 10µm und 50µm, einer elektrisch isolierenden Kunststofffolie (120) mit einer Stärke zwischen 10µm und 50µm und einer Aluminiumfolie (130) mit einer Stärke zwischen 100µm und 400µm. Diese Einzelfolien (110, 120, 130) werden durch ein Klebeverfahren mit einer jeweils ca. 15µm dicken Klebstoffschicht miteinander verbunden und liegen anschließend als Rollenware zur weiteren Verarbeitung vor. Hierbei wird eine Durchbruchspannung zwischen den metallischen Folien von mehr als 3kV erzielt.

In einem nächsten Verarbeitungsschritt werden beide Metallfolien durch Maskierung und einen anschließenden nasschemischen Prozess beidseitig durch Freiätzen von Gräben (112, 132) strukturiert. Hierbei werden die Leiterbahnen (1120) der Hilfs- und Steueranschlüsse auf der Kupferfolie (110) gebildet, diejenigen der Lastanschlüsse bzw. Lastverbindungen auf der Aluminiumfolie (130). Weiterhin werden hierbei die notwendigen, von den anderen Leiterbahnen isolierten, Kontaktinseln auf der Aluminiumfolie (130) gebildet.

Für Hilfs- und Steueranschlüsse werden in einem nächsten Verfahrensschritt Durchkontaktierungen (122) zwischen der Aluminiumfolie (130) und der Kupferfolie (110) ausgebildet. Hierzu werden mittels eines Lasers Sacklöcher durch die Kupfer- (110) und die Isolierfolie (120) bis in die Aluminiumfolie (130) gebohrt und diese anschließend mit einem metallischen Werkstoff verfüllt. Derartige Durchkontaktierungen (122) beispielhaft für Hilfsemitter verbinden Leiterbahnen der Kupferfolie (110) mit Leiterbahnen der Lastanschlüsse bzw. Lastverbindungen der Aluminiumfolie (130). Leiterbahnen für Steueranschlüsse auf der Kupferfolie (110) werden mittels gleichartiger Durchkontaktierungen (122) mit Kontaktinseln auf der Aluminiumfolie (130) verbunden.

Im nächsten Verfahrensschritt werden Kontaktnoppen (140) in dem Folienverbund (100) ausgebildet. Hierzu werden mittels eines Prägewerkzeugs durch Druck auf die Kupferfolie (110) auf der Aluminiumfolie (130) Kontaktnoppen (140) ausgebildet. Die beiden anderen Folien (110, 120) gleichen sich dieser ausgebildeten Kontur an. Die isolierende Folienschicht (120) wird hierbei in ihrer Funktion nicht behindert.

Die Distanzelemente sowie die Leistungshalbleiterbauelemente werden mittels eines Ultraschallschweißverfahrens mit den Kontaktnoppen des Folienverbundes dauerhaft elektrisch leitend verbunden. Somit entsteht ein Verbund aus Leistungshalbeiterbauelementen mit deren "Verdrahtung", dem Folienverbund (100). Dieser Verbund ist einfach und ohne eine Vielzahl serieller Prozesse wie sie bei Drahtbondverbindungen nach dem Stand der Technik notwendig sind, herzustellen.

Dieser bisher erzeugte Verbund wird nun mittels bekannter Verfahren, wie Löten, Kleben mit leitfähigen Klebstoffen oder mittels eines druckkontaktierenden Verfahrens auf dem Substrat angeordnet. Somit entsteht ein äußerst kompakter und stabiler Aufbau eines Leistungshalbleitermoduls, der mittels bekannter Verfahren in einem notwendigen Gehäuse angeordnet werden kann.

## Patentansprüche

1. Leistungshalbleitermodul mit mindestens einem Substrat (300), hierauf schaltungsgerecht angeordneten Leiterbahnen (310), auf diesen Leiterbahnen (310) angeordneten Leistungshalbleiterbauelementen (202, 204),mindestens einem Folienverbund (100) aus mindestens zwei metallischen Folienschichten (110, 130) mit jeweils einer dazwischen angeordneten elektrisch isolierenden Folienschicht (120), wobei der Folienverbund (100) Kontaktnoppen (140) und Durchkontaktierungen (122) aufweist, mindestens eine der metallischen Folienschichten (110, 130) schaltungsgerecht strukturiert (112, 132) ist, und dieser Folienverbund (100) mit den Leistungshalbleiterbauelementen (202, 204) mittels Ultraschallschweißen dauerhaft verbunden ist, wobei
der Folienverbund (100) aus einer die erste metallische Folienschicht bildenden Kupferfolie (110) mit einer Stärke zwischen 10µm und 50µm, einer elektrisch isolierenden Kunststofffolie (120) mit einer Stärke zwischen 10µm und 50µm und einer die zweite metallische Folienschicht bildenden Aluminiumfolie (130) mit einer Stärke zwischen 100µm und 400µm besteht und diese Folienschichten (110, 120, 130) mittels Klebeverbindungen miteinander verbunden sind.

2. Verfahren zur Herstellung eines Leistungshalbleitermoduls mit folgenden aufeinander folgenden Schritten:
• Herstellen eines Folienverbundes (100) aus mindestens zwei metallischen Folienschichten (110, 130) sowie jeweils einer dazwischen angeordneten elektrisch isolierenden Folienschicht (120), wobei dieser Folienverbund (100) aus einer die erste metallische Folienschicht bildenden Kupferfolie (110) mit einer Stärke zwischen 10µm und 50µm, einer elektrisch isolierenden Kunststofffolie (120) mit einer Stärke zwischen 10µm und 50µm und einer die zweite metallische Folienschicht bildenden Aluminiumfolie (130) mit einer Stärke zwischen 100µm und 400µm besteht und diese Folienschichten (110, 120, 130) mittels Klebeverbindungen miteinander verbunden sind;
• Schaltungsgerechte Strukturierung (112, 132) mindestens einer metallischer Folienschicht (110, 130) des Folienverbandes (100);
• Herstellung von schaltungsgerechten Durchkontaktierungen (122) zwischen verschiedenen metallischen Folienschichten (110, 130);
• Ausbildung von Kontaktnoppen (140) auf dem Folienverbund (100);
• Herstellen einer dauerhaften Verbindung zwischen den Kontaktnoppen (140) und den Leistungshalbleiterbauelementen (202, 204) sowie Distanzelementen (206) mittels Ultraschallschweißen und
• Verbinden des Verbundes aus Folienverbund (100), Leistungshalbleiterbauelementen (220, 204) und Distanzelementen (206) mit den Leiterbahnen (310) des Substrats (300) mittels Druckkontaktierung, Löt- oder Klebeverbindung.

3. Verfahren nach Anspruch 2, wobei
die Kontaktnoppen (140) durch ein Prägeverfahren hergestellt sind.

4. Verfahren nach Anspruch 2, wobei
die Strukturierung (112, 132) der metallischen Folienschichten (110, 130) nasschemisch durchgeführt wird.

5. Verfahren nach Anspruch 2, wobei
die Durchkontaktierung (122) mittels Laserbohrens zwischen zwei metallischen Folienschichten (110, 130) und anschließendem lasergestützten Verfüllen mit einem metallischen Werkstoff hergestellt wird.

6. Verfahren nach Anspruch 2, wobei
vor dem letztgenannten Herstellungsschritt auf der ersten metallischen Folienschicht (110) des Folienverbundes (100), also auf der den Leistungshalbleiterbauelementen (202, 204) abgewandten Seite, Bauelemente wie Sensorikbauelemente, Widerstände (160), Kondensatoren, Spulen und / oder integrierte Schaltungen (150) angeordnet werden.

## Claims

1. A power semiconductor module with at least one substrate (300), conducting tracks (310) arranged thereon in a circuit-based manner, power semiconductor elements (202, 204) arranged on the conducting tracks (310), at least one foil laminate (100) consisting of at least two metallic foil layers (110, 130) with an electrically insulating foil layer (120) sandwiched in between each two layers, wherein the foil laminate (100) comprises contact naps (140) and plated-through holes (122), at least one of the metallic foil layers (110, 130) is structured (112, 132) in a circuit-based manner, and this foil laminate (100) is permanently connected to the power semiconductor elements (202, 204) by means of ultrasonic welding, wherein
the foil laminate (100) consists of a copper foil (110) forming the first metallic foil layer with a thickness between 10 µm and 50 µm, an electrically insulating plastic foil (120) with a thickness between 10 µm and 50 µm and an aluminium foil (130) forming a second metallic foil layer with a thickness between 100 µm and 400 µm, and these foil layers (110, 120, 130) are connected with each other via adhesive connections.

2. A method for manufacturing a power semiconductor module comprising the following successive steps:
- Manufacturing a foil laminate (100) from at least two metallic foil layers (110, 130) and an electrically insulating foil layer (120) sandwiched in between each two layers, wherein this foil laminate (100) consists of a copper foil (110) forming the first metallic foil layer with a thickness between 10 µm and 50 µm, an electrically insulating plastic foil (120) with a thickness between 10 µm and 50 µm and an aluminium foil (130) forming the second metallic foil layer with a thickness between 100 µm and 400 µm and these foil layers (110, 120, 130) are connected with each other via adhesive connections;
- Circuit-based structuring (112, 132) of at least one metallic foil layer (110, 130) of the foil laminate (100);
- Manufacturing circuit-based plated-through holes (122) between different metallic foil layers (110, 130);
- Forming contact naps (140) on the foil laminate (100);
- Manufacturing a durable connection between the contact naps (140) and the power semiconductor elements (202, 204) and distance elements (206) by means of ultrasonic welding and
- Connecting the laminate consisting of foil laminate (100), power semiconductor elements (202, 204) and distance elements (206) to the conducting tracks (310) of the substrate (300) by means of pressure-contacting, soldering or bonding by means of adhesive.

3. The method according to claim 2, wherein the contact naps (140) are produced by an embossing process.

4. The method according to claim 2, wherein structuring (112, 132) of the metallic foil layers (110, 130) is carried out by a wet-chemical process.

5. The method according to claim 2, wherein through-plating (122) is produced between two metallic foil layers (110, 130) by means of laser drilling and subsequent laser-based filling-in with a metallic material.

6. The method according to claim 2, wherein prior to the last mentioned manufacturing step components such as sensor elements, resistances (160), capacitors, coils and/or integrated circuits (150) are arranged on the first metallic foil layer (110) of the foil laminate (100), i.e. on the side facing away from the power semiconductor elements (202, 204).

## Revendications

1. Module à semi-conducteurs de puissance comprenant au moins un substrat (300), des pistes conductrices (310) disposées dessus de façon conforme au circuit, des composants à semi-conducteurs de puissance (202, 204) disposés sur ces pistes conductrices (310), au moins un assemblage de film (100) constitué d'au moins deux couches de film (110, 130) métalliques comprenant chacune une couche de film (120) intercalée et électriquement isolante, l'assemblage de film (100) présentant des nopes de contact (140) et des connexions transversales (122), au moins l'une des couches de film (110, 130) métalliques étant structurée (112, 132) de façon conforme au circuit, et cet assemblage de film (100) étant relié en permanence aux composants à semi-conducteurs de puissance (202, 204) par soudage aux ultrasons,
l'assemblage de film (100) à base d'un film de cuivre (110) formant la première couche de film métallique et d'une épaisseur comprise entre 10 µm et 50 µm, d'un film plastique (120) électriquement isolant d'une épaisseur comprise entre 10 µm et 50 µm et d'un film d'aluminium (130) formant la seconde couche de film métallique et d'une épaisseur comprise entre 100 µm et 400 µm et ces couches de film (110, 120, 130) étant reliées les unes aux autres au moyen d'assemblages collés.

2. Procédé pour fabriquer un module à semi-conducteurs de puissance comprenant les étapes suivantes consécutives :
• fabrication d'un assemblage de film (100) à base d'au moins deux couches de film (110, 130) métalliques et de respectivement une couche de film (120) intercalée et électriquement isolante, cet assemblage de film (100) à base d'un film de cuivre (110) formant la première couche de film métallique et d'une épaisseur comprise entre 10 µm et 50 µm, d'un film plastique (120) électriquement isolant d'une épaisseur comprise entre 10 µm et 50 µm et d'un film d'aluminium (130) formant la seconde couche de film métallique et d'une épaisseur comprise entre 100 µm et 400 µm et ces couches de film (110, 120, 130) étant reliées les unes aux autres au moyen d'assemblages collés ;
• structuration conforme au circuit (112, 132) d'au moins une couche de film (110, 130) métallique de l'assemblage de film (100) ;
• fabrication de connexions transversales (122) conformes au circuit entre différentes couches de film (110, 130) métalliques ;
• formation de nopes de contact (140) sur l'assemblage de film (100) ;
• fabrication d'une liaison permanente entre les nopes de contact (140) et les composants à semi-conducteurs de puissance (202, 204) et les éléments d'espacement (206) par soudage aux ultrasons et
• liaison de l'assemblage constitué d'assemblage de film (100), de composants à semi-conducteurs de puissance (220, 204) et d'éléments d'espacement (206) avec les pistes conductrices (310) du substrat (300) par établissement de contact par pression, liaison brasée ou liaison collée.

3. Procédé selon la revendication 2,
les nopes de contact (140) étant fabriquées par un procédé d'estampage.

4. Procédé selon la revendication 2,
la structuration (112, 132) des couches de film (110, 130) métalliques étant réalisée par chimie humide.

5. Procédé selon la revendication 2,
la connexion transversale (122) étant établie par perçage au laser entre deux couches de film (110, 130) métalliques et remplissage consécutif soutenu par laser avec un matériau métallique.

6. Procédé selon la revendication 2,
des composants tels que des composants de capteur, des résistances (160), des condensateurs, des bobines et/ou des circuits intégrés (150) étant disposés avant la dernière étape de fabrication citée sur la première couche de film (110) métallique de l'assemblage de film (100), donc sur le côté opposé aux composants à semi-conducteurs de puissance (202, 204).
